# EUROPEAN PATENT SPECIFICATION

(11) **EP 2 773 534 B1**
(45) Date of publication and mention of the grant of the patent: **23.03.2016**
(21) Application number: 12798002.7
(22) Date of filing: 26.10.2012
(51) Int. Cl.: B60R 16/02, H02G 3/04, H05K 9/00

(54) **WIRE HARNESS WITH PROTECTIVE MEMBER**
KABELBAUM MIT SCHUTZELEMENT
FAISCEAU ÉLECTRIQUE AVEC ÉLÉMENT PROTECTEUR

(30) Priority: 31.10.2011 JP 2011238851
(43) Date of publication of application: 10.09.2014
(73) Proprietor: Yazaki Corporation, Minato-ku Tokyo 108-8333 (JP)
(72) Inventor: ADACHI, Hideomi, Kosai-shi Shizuoka 431-0431 (JP); OZAKI, Yoshiaki, Kosai-shi Shizuoka 431-0431 (JP)
(74) Representative: Grünecker Patent- und Rechtsanwälte PartG mbB
(86) International application number: PCT/JP2012/078410
(87) International publication number: WO 2013/065808

(56) References cited:
- EP-A2- 0 452 942
- EP-A2- 1 469 485
- DE-A1- 3 438 660
- US-A1- 2002 195 260
- US-A1- 2010 206 610
- US-A1- 2011 094 796
- US-B2- 7 094 970
- US-B2- 7 497 284

## Description

### Technical Field

The present invention relates to a wire harness.

### Background Art

A high voltage wire harness is used to electrically connect devices of a hybrid vehicle or an electric vehicle, namely, devices such as a motor unit, an inverter unit or a battery.

A wire harness disclosed in JP 3909763 B2 includes three electric wires which are electrically connected between devices, a main shielding part which accommodates the three electric wires for most of their full length, and sub shielding parts which extend from the ends of the main shielding part and cover the three electric wires. It is possible that the wiring course of the wire harness becomes very long depending on the mounted position of the device.

Each end of the three electric wires is provided with a terminal fitting. The terminal fitting is adapted to be inserted into a shield housing of the device together with the ends of the electric wires, and connected with, for example, bolting to a connecting part disposed at a predetermined position of the device body after the manufacture of the wire harness.

A long metal pipe that has conductivity is used as the main shielding part. To reduce the diameter of the main shielding part, the main shielding part is formed to have such an inside diameter that only the three electric wires can be inserted through.

The sub shielding part includes a braid which is formed into a pipe shape, a shield shell which is fixed to one end of the braid and,a connecting pipe which is fixed to the other end of the braid. The shield shell is included as a part to be connected and fixed to the shield housing of the device.

The braid and the shield shell are fixed by making the braid and the shield shell to be overlapped, placing a shield ring on the overlapped part, and then performing a crimping on the shield ring. The above fixing method is also adopted in the fixation of the braid and the connecting pipe. In other words, the braid and the connecting pipe are fixed by making the braid and the connecting pipe to be overlapped, placing a crimp ring on the overlapped part, and then performing a crimping on the crimp ring.

A metal pipe of the same material and the same inside diameter as the main shielding part is used as the connecting pipe. The connecting pipe has such a length that is remarkably shorter than that of the main shielding part. The connecting pipe is fixed with welding upon making the end of the connecting pipe align with the end of the main shielding part.

It is found in the above construction and structure that, as described above, because the sub shielding part is integrally welded with the main shielding part, the wire harness includes a shielding member formed of a very long metal pipe.

DE 3438660 A discloses a wire harness according to the preamble of claim 1.

### Summary of Invention

### Technical Problem

However, in the above wire harness, although an electromagnetic shielding effect is obtained as an electromagnetic wave measure by using the metal pipe, there is a following problem. That is, because the wire harness includes the shielding member formed of a very long metal pipe, the whole weight of the wire harness is increased. The above problem has an influence on the reduction of the weight of the vehicle.

The present invention is made in view of the above described circumstances, and an object of the present invention is to provide a wire harness so that while an electromagnetic shielding effect is ensured, the wire harness can be lighter in weight and the vehicle can be lighter in weight.

### Solution to Problem

The present invention provides the wire harness, of claim 1.

According to the wire harness having such configuration, the wire harness is provided with the pipe-like protective member which is formed of resin composition that has conductivity. Because the protective member is made of resin composition that has conductivity, the protective member can be lighter in weight than a metal pipe. Further, because the protective member has conductivity, an electromagnetic shielding effect can be also secured.

The wire harness further includes an insulating resin coating that is formed of resin composition having a property of insulating, wherein an outside surface of the protective member is covered with the insulating resin coating.

According to the wire harness having such configuration, because the outside surface of the protective member is covered with the insulating resin coating, while the wire harness is protected from an external force such as an impact, the wiring path of the wire harness can be regulated by the insulating resin coating without providing, for example, an exterior member such as a protector outside the protective member.

The wire harness is configured so that an outside surface of an end part of the protective member is exposed for a predetermined range, and the exposed part is formed as a shielding member connecting part to be connected to a shield member.

According to the wire harness having such configuration, because the outside surface of the end part of the protective member is exposed for a predetermined range and the exposed part is formed as the shielding member connecting part, the protective member has a portion which protects the wire harness from an external force such as an impact, and portions which connect with the shielding members such as the braids.

The wire harness further includes a braid that is connected and fixed to an end part of the protective member.

The wire harness is configured so that a braid is connected and fixed to each of both ends of the protective member, and the protective member is extended along an entire length between the both ends connected and fixed to the braids.

### Advantageous Effects of Invention

According to the aspect of the invention, because the wire harness is provided with the protective member formed of resin composition that has conductivity, an effect is achieved that while an electromagnetic shielding effect is secured, the wire harness can be lighter in weight and the vehicle can be lighter in weight.

According to the further configuration of the wire harness, the following effects are also achieved. In other words, because the outside surface of the protective member is covered with the insulating resin coating, an effect is achieved that a protection function in the wire harness can be improved. Further, because the wiring path of the wire harness can be regulated by the insulating resin coating, since it is not necessary to provide an exterior member such as a protector, an effect is achieved that the number of components related to the wiring path regulation of the wire harness and the operating man-hours related to the assembly of the exterior member can be reduced. An effect is achieved that the wire harness can be provided so that the manufacturing cost can be reduced and the operability can be improved.

According to the further configuration of the wire harness, the following effects are also achieved. In other words, because the protective member has a portion which protects the wire harness from an external force such as an impact, and portions which connect shielding members such as the braids, an effect is achieved that while a protection function is secured, the portions connecting to the shielding members at the end parts of the protective member can be secured.

### Brief Description of Drawings

Fig. 1 is a schematic diagram of a vehicle in which a wire harness according to an embodiment of the present invention is wired.
Fig. 2 is a cross-sectional view which shows a construction of a wire harness.
Fig. 3 is a cross-sectional view which shows a construction of a protective member.
Fig. 4 is a cross-sectional view which shows a construction of a wire harness according to an embodiment.
Fig. 5 is a cross-sectional view which shows a construction of a protective member according to an embodiment.

### Description of Embodiments

A wire harness includes a plurality of high voltage electric wires (conducting paths), a protective member which collectively covers and shields the plurality of high voltage electric wires, and terminal shielding members which are connected to two end part parts of the protective member.

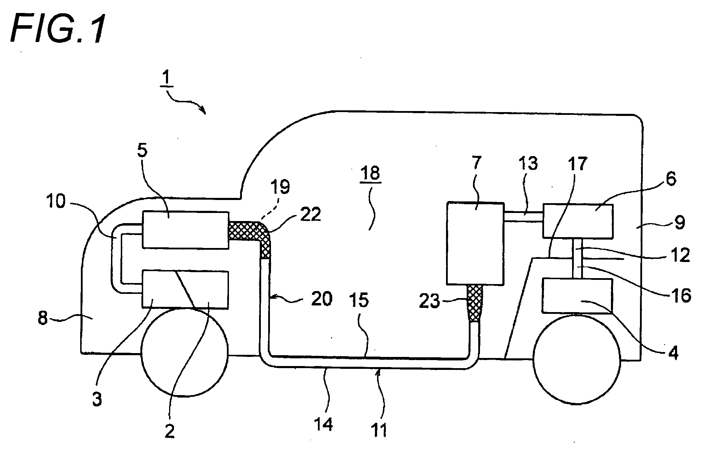

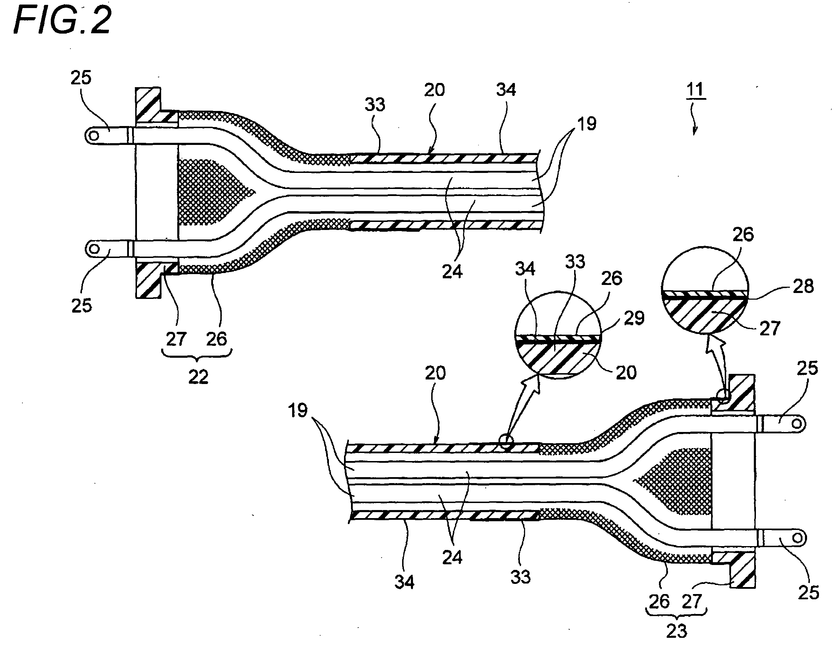

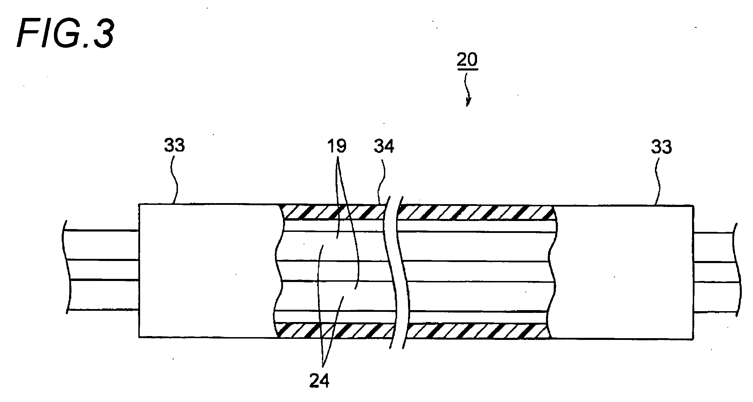

Fig. 1 is a schematic diagram of a vehicle in which a wire harness according to the embodiment of the present invention is wired. Fig. 2 is a cross-sectional view which shows a construction of the wire harness. Fig. 3 is a cross-sectional view which shows a construction of a protective member.

In the following description, specific shapes, materials, numerical values, directions and the like are illustrated to facilitate the understanding of the present invention and may be changed appropriately depending on applications, objects, specifications or the like.

In the embodiment, an example in which a wire harness middle member and a wire harness is applied to a hybrid vehicle (it may be an electric vehicle) is given and described.

Fig. 1 shows a hybrid vehicle 1. The hybrid vehicle 1 is a vehicle which is driven by using an engine 2, a front motor unit 3 and a rear motor unit 4 together, and electric power from a battery 7 (battery pack or unit battery) is adapted to be supplied to the front motor unit 3 through a front inverter unit 5 and to the rear motor unit 4 through a rear inverter unit 6. The engine 2, the front motor unit 3 and the front inverter unit 5 are mounted in an engine room 8 at the position of front wheels and the like in the first embodiment. The rear motor unit 4, the rear inverter unit 6 and the battery 7 are mounted in a vehicle rear part 9 of rear wheels and the like. The mounted positions shall be an example. The position of the battery 7 shall not be particularly limited as long as the battery 7 can be used in the hybrid vehicle 1 or an electric vehicle.

The front motor unit 3 and the front inverter unit 5 are connected by a high voltage wire harness 10. The front inverter unit 5 and the battery 7 are also connected by a high voltage wire harness 11. The rear motor unit 4 and the rear inverter unit 6 are also connected by a high voltage wire harness 12. The rear inverter unit 6 and the battery 7 are also connected by a high voltage wire harness 13.

A middle part 14 of the wire harness 11 is wired at the ground side of a vehicle body floor 15. The wire harness 11 is wired generally in parallel with the vehicle body floor 15. The vehicle body floor 15 is a well-known body and is a so-called panel member, and through holes (reference numbers are omitted) are formed at predetermined positions. The through holes correspond to parts to which the wire harness 11 is inserted.

The wire harness 12 is wired so that a middle part 16 of the wire harness 12 penetrates through a vehicle body floor 17 in the vehicle rear part 9. A through hole into which the wire harness 12 is inserted is formed like the through holes of the wire harness 11. A reference number 18 indicates an indoor part.

Because the wire harness 10 is connected to the front motor unit 3 and because the wire harness 12 is connected to the rear motor unit 4, the wire harness 10 and the wire harness 12 may be called a motor cable or a motor cable device. In addition, because the wire harness 11 is wired under the vehicle body floor 15, the wire harness 11 may be called an underfloor wire harness. . The following can be applied to not only the wire harness 11, but also the wire harness 10, 12 and 13.

The wire harness 11 is intended to electrically connect the front inverter unit 5 to the battery 7 (refer to Fig. 1), and includes two high voltage electric wires 19 (or referred to as conducting paths), a protective member 20 which is also used as a shielding member to collectively cover and shield the two high voltage electric wires 19, and two flexible terminal shielding members 22 and 23, as shown in Fig. 2. The protective member 20 of the wire harness 11 is formed of a resin composition that has conductivity formed into a pipe shape. Because the protective member 20 is also used as a shielding member as described above, the protective member 20 corresponds to a member that plays a shielding function.

As described above, the protective member 20 is made of a resin composition that has conductivity. As shown in Figs. 2 and 3, the protective member 20 is formed to have such a size (diameter) and such a length that a predetermined range of the two high voltage electric wires 19 can be covered with the protective member 20. The protective member 20 is molded by extruding a resin composition that has conductivity into a pipe shape of a circular cross section. What is formed by mixing a conductive material with a resin material is cited as the resin composition that has conductivity. In particular, what is formed by mixing carbon fiber with resin materials such as PBT (polybutylene terephthalate) is cited as an example. Because the protective member 20 is not made of metal, but is made of resin, the protective member 20 becomes lightweight.

The high voltage electric wire 19 is a high voltage conducting path including a conductor and an insulator (coating) 24, and is formed to have a length that is necessary for electrical connection. The conductor (not shown in the figure) is made of copper, copper alloy, aluminum or aluminum alloy. The conductor may be either a conductor structure in which strands are twisted or a rod-like conductor structure whose cross section is a rectangular shape or a round shape (for example, a conductor structure with a rectangular single core or a round single core, and in this case, the electric wire itself becomes rod-like).

The high voltage electric wires 19 are used in the present embodiment, but the invention shall not be limited to this. That is, it is also possible to provide an insulator to a well-known bus bar to be used as a high voltage conducting path.

A predetermined length of the insulator 24 at each end of the high voltage electric wire 19 is removed. From this removed portion, a conductor (not shown in the figure) is exposed. A terminal fitting 25 is connected to the exposed conductor (refer to Fig. 2). The terminal fitting 25 is provided as a part connected to a connecting part, which is not shown, of the front inverter unit 5, or as a part connected to a connecting part, which is not shown, of the battery 7.

In Fig. 1, one terminal shielding member 22 is provided as a connecting member to the front inverter unit 5, and the other terminal shielding member 23 is provided as a connecting member to the battery 7. While the terminal shielding member 22 is connected to one end of the protective member 20, the terminal shielding member 23 is connected to the other end of the protective member 20.

Each of the two terminal shielding members 22 and 23 includes a braid 26 and a shield shell 27 which is electrically connected to one end of the braid 26, as shown in Fig. 2. The shield shell 27 which forms the terminal shielding member 22 is formed to be connected and fixed to a shield housing of the front inverter unit 5. The shield shell 27 which forms the terminal shielding member 23 is formed to be connected and fixed to the battery 7.

The braid 26 is formed as a pipe-like electromagnetic shielding member (a shielding member for electromagnetic wave measures). The braid 26 is formed to have such a size that a predetermined range of the two high voltage electric wires 19 can be covered with the braid 26, as shown in Fig. 2. The braid 26 is formed by using a lot of extra-fine strands that have conductivity, and braiding these strands into a net-like shape.

The above strand may be an extra-fine strand including a metal strand such as an annealed copper strand, or a nonmetal fiber. The nonmetal fiber may be a conductive resin fiber in which conductive material is mixed with carbonaceous fiber or resin material. Other than these strands, for example, a resin strand (PET (polyethylene terephthalate) strand) may be mixed to possess abrasion resistance. In order to connect and fix the braid 26 to the end part 33 of the protective member 20 and the shield shell 27 to be described below with welding, the braid 26, which is formed by braiding conductive resin fiber into a net-like shape, is used. This is an example and the invention is not limited to this.

A conductive resin shield shell made of resin composition that has conductivity is used as the shield shell 27 in the embodiment, but, besides this, for example, a shield shell made of metal that has conductivity may be used. The connection and fixation of the braid 26 and the shield shell 27 may be performed by, for example, welding, adhering or soldering the connecting points of the braid 26 and the shield shell 27. As an example of the connection with the welding, the braid 26, which is formed by braiding conductive resin fibers into a net-like shape, and the shield shell 27 made of conductive resin composition are welded as shown in Fig. 2, and, are connected and fixed by a connecting portion 28 formed between the braid 26 and the outer peripheral surface of the shield shell 27. Therefore, it is not necessary to perform a crimping operation with a shield ring or the like at the portion where the braid 26 and the shield shell 27 overlap, and the number of components and the operating man-hours related to the manufacture of the wire harness 11 can be reduced. That is, the manufacturing cost related to the manufacture of the wire harness 11 can be reduced and the operability in the manufacture of the wire harness 11 can be improved.

Then, the connection and fixation of the end part 33 of the protective member 20 and the braid 26 is described.

The other end of the braid 26 is formed to be connected and fixed to the end part 33 of the protective member 20. The connection and fixation of the protective member 20 and the braid 26 may be performed by, for example, welding, adhering or soldering the connecting points of the protective member 20 and the braid 26. As an example of the connection with the welding, the end part 33 of the protective member 20 and the braid 26, which is formed by braiding conductive resin fibers into a net-like shape, are welded as shown in Fig. 2, and are connected and fixed by a connecting portion 29 formed between the braid 26 and the outside surface 34 of the end part 33 of the protective member 20. Therefore, it is not necessary to performing a crimping operation with a crimp ring or the like at the portion where the end part 33 of the protective member 20 and the braid 26 overlap, and the number of components and the operating man-hours related to the manufacture of the wire harness 11 can be reduced. That is, the manufacturing cost related to the manufacture of the wire harness 11 can be reduced and the operability in the manufacture of the wire harness 11 can be improved.

As described above with reference to Figs. 1 to 3, the wire harness 11 is provided with the protective member 20 which is formed of resin composition that has conductivity and is lighter than a metal pipe. Thus, an effect is achieved that it is possible to provide the wire harness 11 so that while an electromagnetic shielding effect is ensured, the wire harness 11 can be lighter in weight and the vehicle can be lighter in weight.

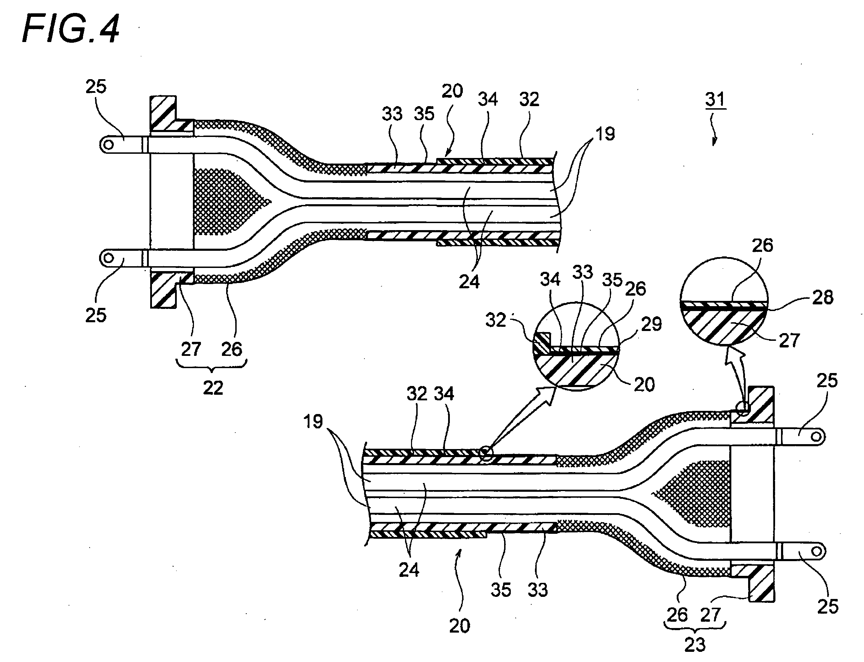

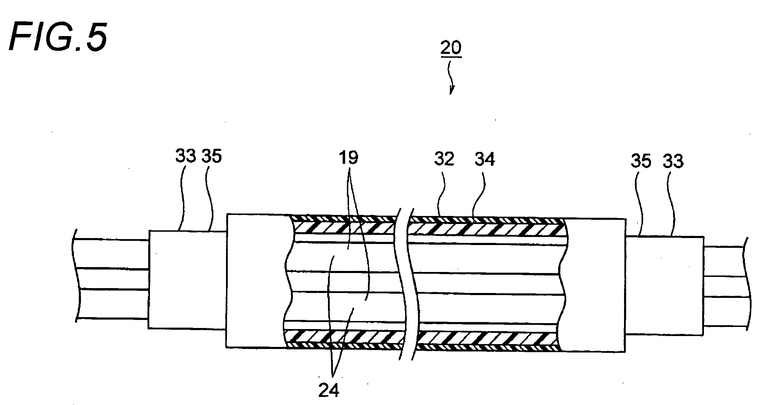

Next, an embodiment is described with reference to the figures. Fig. 4 is a cross-sectional view which shows a construction of a wire harness. Fig. 5 is a cross-sectional view which shows a construction of a protective member.

The embodiment is the same as the first harness except that an insulating resin coating 32 to be described below is provided on the outside surface 34 of the protective member 20 of the wire harness. Thus, the insulating resin coating 32 is described as follows.

In Figs. 4 and 5, in the embodiment, the insulating resin coating 32 is further formed on the outside surface 34 of the protective member 20 of the wire harness 31. The insulating resin coating 32 is formed as a layer which corresponds to the upper layer of the protective member 20, and which is made of resin composition having the property of insulating. The insulating resin coating 32 is formed by overmolding the resin having the property of insulating on the outside surface 34 of the protective member 20 after the protective member 20 is molded. In other words, the protective member 20 is formed to have a structure of two layers made of a first layer and a second layer in the embodiment. The protective member 20 is equivalent to the first layer, and the insulating resin coating 32 formed as the upper layer of the protective member 20 is equivalent to the second layer.

By forming the insulating resin coating 32 on the outside surface 34 of the protective member 20 according to the present embodiment, while the wire harness 31 is protected from an external force such as an impact, the wiring path of the wire harness 31 can be regulated by the insulating resin coating 32 without providing, for example, an exterior member such as a protector outside the protective member 20.

As shown in Fig. 5, in the present embodiment, the insulating resin coating 32 is not formed on the outside surface 34 of the protective member 20 at areas of end parts 33 of the protective member 20, but the outside surface 34 at the end parts 33 of the protective member 20 is exposed. The outside surface 34 at the end parts 33, which is exposed, of the protective member 20, is formed as shielding member connecting parts 35.

In Fig. 4, the other ends of the braids 26, which are members constructing the terminal shielding members 22 and 23 and one end of each of which is connected to the outer peripheral surface of the shield shell 27, are connected to the shielding member connecting parts 35 of the protective member 20, respectively. The connection of the braids 26 and the shielding member connecting parts 35 shall be performed with welding in the present embodiment. This shall be an example. The braids 26 and the shielding member connecting parts 35 are connected and fixed by connecting portions 29 formed between the braids 26 and the shielding member connecting parts 35. A braid formed by braiding conductive resin fibers into a net-like shape and a shield shell formed of conductive resin composition may be used as the braid 26 and the shield shell 27 in the present embodiment. This shall be an example.

In the embodiment, the terminal shielding members 22 and 23 can be connected and fixed to the shielding member connecting parts 35 of the protective member 20 with welding beforehand, welding, adhering, soldering or the like. Thus, because the terminal shielding members 22 and 23 can be formed integrally with the protective member 20 as one member, the number of components and the operating man-hours related to the manufacture of the wire harness 31 can be reduced. Thus, the manufacturing cost related to the manufacture of the wire harness 31 can be reduced and the operability in the manufacture of the wire harness 31 can be improved.

As described above with reference to Figs. 1 to 5, the wire harnesses 11 and 31 are provided with the protective member 20 which is formed of resin composition that has conductivity. Thus, besides the effect that while an electromagnetic shielding effect is ensured, the wire harnesses 11 and 31 can be lighter in weight and the vehicle can be lighter in weight, the following effects are achieved.

According to the embodiment of the present invention, because the outside surface 34 of the protective member 20 is covered with the insulating resin coating 32, an effect is achieved that a protection function in the wire harness 31 can be improved. Further, because the wiring path of the wire harness 31 can be regulated by the insulating resin coating 32, since it is not necessary to provide an exterior member such as a protector, an effect is achieved that the number of components related to the wiring path regulation of the wire harness 31 and the operating man-hours related to the assembly of the exterior member can be reduced. An effect is achieved that the wire harness 31 can be provided so that the manufacturing cost can be reduced and the operability can be improved.

Further, according to the embodiment of the present invention, because the protective member 20 has a portion which protects the wire harness 31 from an external force such as an impact, and portions which connect shielding members such as the braids 26, an effect is achieved that while a protection function is secured, the portions connecting to the shielding members at the end parts 33 of the protective member 20 can be secured.

In addition, it is apparent that various modifications can be made to the invention without changing the purpose of the invention.

### Industrial Applicability

The present invention is useful because the wire harness includes a protective member that accommodates the one or more conducting paths in the protective member is formed of resin composition that has conductivity, thereby an entire of vehicle in which the wire harness is mounted can be light and an electromagnetic shielding effect can be also secured.

### Reference Signs List

1: hybrid vehicle
2: engine
3: front motor unit
4: rear motor unit
5: front inverter unit
6: rear inverter unit
7: battery
8: engine room
9: vehicle rear part
10 to 13, 31: wire harness
14, 16: middle part
15, 17: vehicle body floor
18: indoor part
19: high voltage electric wire (conducting path)
20: protective member
22, 23: terminal shielding member
24: insulator
25: terminal fitting
26: braid
27: shield shell
28, 29: connecting portion
32: insulating resin coating
33: end part
34: outside surface
35: shielding member connecting part

## Claims

1. A wire harness, comprising:
one or more conducting paths (19);
a protective member (20) that is formed in a pipe shape, and accommodates the one or more conducting paths in the protective member to shield a electromagnetic wave emitted from the one or more conducting paths, wherein
the protective member is formed of resin composition that has conductivity;
an insulating resin coating (32) that is formed of resin composition having a property of insulating, wherein an outside surface of the protective member is covered with the
insulating resin coating; **characterised by**
a braid (26) that is connected and fixed to an end part (33) of the protective member, wherein
an outside surface (34) of an end part of the protective member is exposed for a predetermined range, and the exposed part is formed as a shielding member connecting part (35) to be connected to the braid (26).

2. The wire harness according to claim 1, wherein a braid is connected and fixed to each of both ends of the protective member, and the protective member (20) is extended along an entire length between the both ends connected and fixed to the braids (26).

## Patentansprüche

1. Ein Kabelbaum, aufweisend:
einen oder mehrere leitende Pfade (19),
ein Schutzglied (20), das in einer rohrförmigen Gestalt geformt ist und das den einen oder die mehreren leitenden Pfade in dem Schutzglied unterbringt um eine elektromagnetische Strahlung abzuschirmen, die von dem einem oder den mehreren leitenden Pfaden imitiert wird, wobei
das Schutzglied aus einer Kunststoffzusammensetzung geformt ist, die leitfähig ist,
ein isolierenden Kunststoffüberzug (32), der aus einer Kunststoffzusammensetzung mit einer isolierenden Eigenschaft geformt ist, wobei eine äußere Oberfläche des Schutzglieds mit dem isolierenden Kunststoffüberzug bedeckt ist, **gekennzeichnet durch**
eine Umflechtung (26) die an einem Endteil (33) des Schutzglieds verbunden und fixiert ist, wobei eine äußere Oberfläche (34) eines Endteiles des Schutzglieds mit einer vorbestimmten Länge freiliegt, und der freiliegende Teil als ein Abschirmgliedverbindungsteil (35) geformt ist, welches mit der Umflechtung (26) verbunden ist.

2. Der Kabelbaum gemäß Anspruch 1, wobei eine Umflechtung mit jedem der beiden Enden des Schutzglieds verbunden und fixiert ist, und sich das Schutzglied (20) entlang einer gesamten Länge zwischen den beiden Enden erstreckt die mit der Umflechtung (26) verbunden und fixiert sind.

## Revendications

1. Faisceau de câbles, comprenant :
un ou plusieurs chemins conducteurs (19) ;
un élément protecteur (20) qui est mis en forme de tuyau, et qui héberge le un ou plusieurs chemins conducteurs dans l'élément protecteur pour protéger une onde électromagnétique émise depuis le un ou plusieurs chemins conducteurs, où
l'élément protecteur est formé de composition de résine présentant une certaine conductivité ;
un revêtement de résine isolante (32) qui est formé d'une composition de résine ayant une propriété d'isolation, où une surface externe de l'élément protecteur est recouverte du revêtement de résine isolante ; **caractérisé en ce que**
une tresse (26) qui est connectée et fixée à une partie d'extrémité (33) de l'élément protecteur, où une surface externe (34) d'une partie d'extrémité de l'élément protecteur est exposée sur une étendue prédéterminée, et la partie exposée est mise sous forme d'un élément gainant connectant la partie (35) à connecter à la tresse (26).

2. Faisceau de câbles selon la revendication 1, où
la tresse est connectée et fixée à chacune des deux extrémités de l'élément protecteur, et
l'élément protecteur (20) s'étend le long d'une longueur entière entre les deux extrémités connectées et fixées aux tresses (26).
